# EUROPÄISCHE PATENTSCHRIFT

(11) **EP 0 831 375 B1**
(45) Veröffentlichungstag und Bekanntmachung des Hinweises auf die Patenterteilung: **19.03.2003**
(21) Anmeldenummer: 97115970.2
(22) Anmeldetag: 13.09.1997
(51) Int. Cl.: G03F 7/033, G03F 3/10

(54) **Verfahren zur Herstellung von Farbprüfdrucken**
Process for the production of colour proofs
Procédé pour la production des épreuves en couleur

(30) Priorität: 18.09.1996 DE 19638032
(43) Veröffentlichungstag der Anmeldung: 25.03.1998
(73) Patentinhaber: Du Pont de Nemours (Deutschland) GmbH, 61343 Bad Homburg (DE); E.I. Du Pont de Nemours & Company, Wilmington, Delaware 19898 (US)
(72) Erfinder: Sondergeld, Manfred, Dr., 63165 Mühlheim/Main (DE)

(56) Entgegenhaltungen:
- EP-A- 0 651 290
- DE-A- 2 205 146
- DE-A- 4 446 869
- US-A- 4 273 857

## Beschreibung

Die Erfindung betrifft ein Verfahren zur Herstellung von Farbprüfdrucken umfassend ein photopolymerisierbares Aufzeichnungsmateral enthaltend a) ein polymeres Bindemittel mit salzbildenden Gruppen oder ein Bindemittelgemisch mit wenigstens einem Polymeren mit salzbildenden Gruppen, b) mindestens ein photopolymerisierbares Monomer und c) einen Photoinitiator oder ein Photoinitiatorsystem, ein photopolymerisierbares Aufzeichnungsmaterial und ein Verfahren zur Herstellung von Farbprüfdrucken.

In der Reproduktionstechnik werden gerasterte Farbauszüge als Kopiervorlagen für die Herstellung von Offset- oder Hochdruckplatten verwendet. Bevor die Belichtung der Druckplatten erfolgt, werden die Farbauszüge mit Hilfe von Farbprüfverfahren daraufhin überprüft, ob das spätere Druckergebnis eine tonwertrichtige Reproduktion der Vorlage darstellt.

In solchen Farbprüfverfahren finden lichtempfindliche Aufzeichnungsmaterialien Verwendung, bei denen zur Bilderzeugung Unterschiede in der Klebrigkeit der belichteten und unbelichteten Bereiche der lichtempfindlichen Schicht ausgenutzt werden. So ist z.B. aus den deutschen Patentschriften 12 10 321, 19 04 058, 19 04 059 und 20 04 214, der EP-B 0 243 932 und der EP-B 02 43 933 ein Reproduktionsverfahren bekannt, bei dem ein klebriges photopolymerisierbares Aufzeichnungsmaterial, bestehend aus einem Schichtträger, einer photopolymerisierbaren Schicht, die mindestens ein additionspolymerisierbares Monomeres und einen Photopolymerisationsinitiator enthält, und einer Deckfolie verwendet wird. Diese Deckfolie wird abgezogen, das Material wird auf einen Bildträger auflaminiert und durch bildmäßige Belichtung gehärtet, wobei die belichteten Bildteile ihre Klebrigkeit verlieren. Der Schichträger kann je nach Material vor oder nach der Belichtung abgezogen werden.

Das latente Bild wird dann durch Aufbringen geeigneter Tonermaterialien sichtbar gemacht, die nur an den unbelichteten, klebrigen Stellen haften, während sie von den belichteten, nicht klebenden Bildteilen nach dem Aufbringen wieder entfernt werden können. Nach diesem Verfahren erhält man positive, gegebenenfalls gefärbte Bilder der Vorlage, die im Aussehen Bildern gleichen, die unter Verwendung von Druckfarben hergestellt wurden.

Das Aufbringen der überwiegend aus feinteiligen Pulvern bestehenden Tonermaterialien kann durch Bestäuben der bildmäßig belichteten Oberfläche mit dem Toner erfolgen. Nach einer anderen Ausführungsform kann sich der Toner auch lose gebunden auf einem gesonderten Träger befinden und durch Inkontaktbringen dieses Trägers mit der bildmäßig belichteten Schicht übertragen werden. In DE-C 36 25 014, DE-C 39 41 446 und DE-C 39 41 493 oder auch in EP-A 0 365 361 werden Farbprüfverfahren beschrieben, in denen spezielle, hierfür entwickelte Übertragungsschichten verwendet werden.

Zwar können mit diesen bekannten Verfahren die wichtigsten Anforderungen der Druckindustrie, wie hohe Auflösung, gute Tonwertwiedergabe und geringer Punktzuwachs, erfüllt werden. Jedoch zeigen die bekannten Materialien, insbesondere solche, die die in der EP-B 0 243 932 und der EP-B 02 43 933 als besonders bevorzugt beschriebenen Monomere vom Typ der (meth)acrylierten Bisphenol-A-Epoxid-Harze enthalten, eine zu hohe Haftung an der Trägerfolie, was zu Löchern der Photopolymerschicht, sogenannten "pinholes", auf dem Papier führt, oder auch "reverse adhesion", d. h. die Photopolymerschicht wird beim Abziehen der Deckfolie in mehr oder weniger großen Stücken von der Trägerfolie abgelöst, so daß keine brauchbaren Farbprüfdrucke hergestellt werden können.

Photopolymerisierbare Schichten, die keine Monomere vom Typ der (meth)acrylierten Bisphenol-A-Epoxid-Harze enthalten, zeigen diese Effekte nicht. Aber die Sauerstoffempfindlichkeit, insbesondere von dünnen photopolymerisierbaren Schichten, steigt derart an, dass die zwischen Papier und photopolymerisierbarer Schicht eingeschlossenen Luft die Photopolymerisation so stark behindert, dass die Oberfläche der Schicht auch in den belichteten Bereichen weiterhin klebrig bleibt und Toner annimmt. Dieser Effekt ist als "pepper stain" bekannt.

In der US 4,273,857 und in der DE-A 22 05 146 werden wäßrig alkalisch entwickelbare photopolymerisierbare Gemische zur Herstellung von Photoresists beschrieben, welche sowohl Vinylacetatcopolymere als auch polymere Bindemittel mit salzbildenden Gruppen enthalten. In der DE-A 44 46 869 wird eine Verfahren zur Herstellung von mehreren Farbprüfdrucken beschrieben, bei dem die photopolymerisierbare Schicht vemetzbare polymere Bindemittel mit salzbildenden Gruppen enthält und ggf. weitere nicht vernetzbare Bindemittel wie z.B. Polyacrylate, Polystyrole oder Polyvinylacetate.

Der vorliegenden Erfindung lag daher die Aufgabe zugrunde, ein Verfahren zur Verfügung zu stellen, mit dem fehlerfreie Farbprüfdrucke mit hoher Auflösung, guter Tonwertwiedergabe und geringem Punktzuwachs hergestellt werden können.

Diese Aufgabe wird gelöst durch ein Verfahren zur Herstellung von Farbprüfdrucken umfassend, a) Abziehen des Schichtträgers eines photopolymerisierbaren Aufzeichnungsmaterials umfassend einen Schichtträger, eine photopolymerisierbare Schicht, welche ein polymeres Bindemittel mit salzbildenden Gruppen oder ein Bindemittelgemisch mit wenigstens einem Polymeren mit salzbildenden Gruppen, mindestens ein photopolymerisierbares Monomer und einen Photoinitiator oder ein Photoinitiatorsystem enthält, und eine Deckfolie, b) Laminieren des photopolymerisierbaren Aufzeichnungsmaterials mit der photopolymerisierbaren Schicht auf ein Bildträgermaterial, c) ggf. Abziehen der Deckfolie, d) bildmäßiges Belichten der photopolymerisierbaren Schicht zur Erzeugung klebriger und nicht klebriger Bereiche, e)Entfernen der Deckfolie, falls dies noch nicht unter c) erfolgt ist, und f) Aufbringen von Toner auf die klebrigen Bereiche der bildmäßig belichteten Schicht, dadurch gekennzeichnet, dass die photopolymerisierbare Schicht mindestens 10 Gew.-% wenigstens eines Vinylacetathomopolymeren und/oder copolymeren bezogen auf den Gesamtfeststoffgehalt der photopolymerisierbaren Schicht enthält.

Überraschenderweise zeigen photopolymerisierbare Gemische mit Zusatz von Vinylacetathomopolymeren oder -copolymeren weder eine zu große Haftung zur Deckfolie noch zum Schichträger, so daß die bei Gemischen des Standes der Technik auftretenden Fehler beim Abziehen der Deckfolie bzw. des Schichträgers nicht beobachtet werden.

Ein weiterer überraschender Vorteil der erfindungsgemäßen Gemische ist ihre geringere Sauerstoffempfindlichkeit. Sogar photopolymerisierbare Schichten mit niedrigen Schichtdicken, z. B. 4 µm, zeigen keine Aufnahme von Tonermaterial in den photopolymerisierten, nicht-klebrigen Bereichen. Insbesondere die Verringerung der Sauerstoffempfindlichkeit von Acrylatsystemen war nicht vorhersehbar, da Polyvinylacetate mit Acrylatsystemen unverträglich sind und durch die stattfindende Phasentrennung in polymerreiche Polyvinylacetatphase und monomerreiche Acrylatphase kein Einfluß auf die Sauerstoffempfindlichkeit des Systems zu erwarten war.

Bei den erfindungsgemäßen Polymeren handelt es sich um Homooder Copolymere von Vinylacetat. Auch partiell verseifte Polymere sind verwendbar. Geeignete Comonomere sind carboxylgruppenhaltige Verbindungen wie z. B. Crotonsäure.

Bevorzugt werden Vinylacetathomopolymere und Vinylacetat/Crotonsäure-Copolymere verwendet, die üblicherweise ein mittleres Molekulargewicht M_{w} (Gewichtsmittel) von 30000 - 1000000, bevorzugt 35000 - 150000 aufweisen.

Die erfindungsgemäßen photopolymerisierbaren Gemische enthalten mindestens 10 Gew.-% Vinylacetathomo- und/oder copolymer bezogen auf den Gesamtfeststoffgehalt des photopolymerisierbaren Gemischs, bevorzugt 18 - 40 Gew.-%. Aber auch ein höherer Anteil der erfindungsgemäßen Polymere ist möglich

Als weitere polymere Bindemittel der photopolymerisierbaren Schichten können z. B. thermoplastische Bindemittel auf Acrylat und/oder Methacrylatbasis verwendet werden. Bevorzugt werden Polymere mit einer Glasübergangstemperatur von < 70°C und Polymermischungen mit Glasübergangstemperaturen der einzelnen Polymere von < 80°C eingesetzt. Insbesondere die in der EP-A 0 243 933 genannten, vernetzungsfähigen, salzbildende Gruppen enthaltenden Polymere sind für die erfindungsgemäßen Gemische als Co-Bindemittel geeignet. Dies sind bevorzugt COOH-Gruppen enthaltende Polyacrylate, Polymethacrylate oder Copolymere von Acrylsäure bzw. Methacrylsäure mit anderen Monomeren, wie z.B. (Meth)acrylsäureestern und/oder andere (Meth)acrylsäurederivaten, Vinylverbindungen, Styrol, Butadien und verwandte Monomere. Bevorzugt werden thermoplastische Polymere auf Acrylat- und/oder Methacrylatbasis eingesetzt, besonders bevorzugt Copolymere von (Meth)acrylsäure mit Methyl- und/oder Ethylacrylat bzw. -methacrylat.

Die Vernetzung der COOH-Gruppen erfolgt bevorzugt mittels mehrwertiger Metallverbindungen aus den Gruppen II A - IV A, II B - IV B und VII B des Periodensystems, insbesondere über Zinkverbindungen. Die Metallverbindungen können der photopolymerisierbaren Schicht. z.B. in Form ihrer Salze, Oxide und Alkoxide oder als Chelate zugesetzt werden. Diese Verbindungen werden in solchen Mengen zugesetzt, daß mindestens 10 Gew.-% der vorhandenen salzbildenden Gruppen des polymeren Bindemittels vernetzt werden.

Die Gesamtmenge der polymeren Bindemittel beträgt im allgemeinen 20 - 80 Gew.-%, bevorzugt 30 - 60 Gew.-%, bezogen auf den Feststoffgehalt des photopolymerisierbaren Gemischs.

Weitere Bestandteile der photopolymerisierbaren Schichten sind bekannte ethylenisch ungesättigte Monomere und Oligomere, wie sie auch in der EP-B 0 243 933 beschrieben sind. Bevorzugt werden Verbindungen mit mehreren additionspolymersierbaren, ethylenisch ungesättigten Gruppen verwendet. Es sind auch Kombinationen dieser Verbindungen möglich. Besonders geeignet sind Acryl- und Methacrylsäureester von mehrwertigen alicyclischen und cyclischen Polyolen, wie z.B. Ethylendiacrylat, Diethylenglykoldiacrylat, Glycerin-di- und -triacrylat, 1,3-Propandioldimethacrylat, 1,2,4-Butantrioltrimethacrylat, Pentaerythritoltetramethacrylat, Trimethylolpropantrimethacrylat, polyoxyethyliertes Trimethylolpropanacrylat oder -methacrylat, Hexamethylendioldiacrylat. Die Monomere werden üblicherweise in Mengen von 10 bis 80 Gew.% bezogen auf den Gesamtfeststoffgehalt, bevorzugt 20 bis 60 Gew.%, verwendet.

Als Photoinitiatoren können praktisch alle für diesen Zweck bekannten Verbindungen, die auch in der EP 0 243 933 genannt sind, in Mengen von 0,01 bis 15 Gew.% bezogen auf den Gesamtfeststoffgehalt verwendet werden. Beispielhaft seien genannt: Benzil, Benzildimethylketal, Benzoin, Benzoinisopropylether, a-Methylbenzoin, 1,4-Naphthochinon, Michler's Keton und Benzophenon, sowie Systeme aus substituierten Thioxanthonen und tertiären Aminen.

Desweiteren können 5 - 30 Gew.% eines oder mehrerer Weichmacher verwendet werden, z.B. Alkylphosphate, Polyethylenglykole, Polyhydroxyethylenglykolether, Diester von Phthalsäure, Adipinsäure und Capronsäure. Bevorzugt werden flüssige Acrylat- bzw. Methacrylatpolymere oder Butadien/Acrylnitril-Copolymere mit salzbildenden Gruppen verwendet.

Außer den bereits genannten Bestandteilen können die photopolymerisierbaren Schichten noch weitere Zusätze enthalten, wie z.B. Sensibilisatoren, Füllstoffe, thermische Stabilisatoren, Antioxidantien, Gießhilfsmittel und dgl.

Die photopolymerisierbaren Gemische können nach bekannten Verfahren aus gängigen Lösungsmitteln, bevorzugt aus organischen Lösungsmitteln, wie z.B. Methylenchlorid, Toluol/Methanol-Mischungen oder andere Mischungen aus aromatischen Lösungsmitteln und Alkoholen, Estern oder Ketonen, auf geeignete Schichtträger aufgetragen und anschließend getrocknet werden.

Geeignete Schichtträger sind z.B. Kunststoffolien aus Polyethylen, Polypropylen, Polyamiden oder Polyestern. Besonders bevorzugt werden Polyethylenterephthaltfolien verwendet, insbesondere in einer Dicke von ≥ 12 µm. Bei der Verwendung von nichttransparenten Schichtträgern, werden diese vor der bildmäßigen Belichtung abgezogen.

Als Deckfolie werden flexible Kunststoffolien wie z.B. Polyethylen- und Polypropylenfolien verwendet, insbesonders Polypropylenfolien in einer Dicke von 10 - 24 µm.

Die Schichtdicke der photopolymerisierbaren Aufzeichungsschicht liegt bevorzugt zwischen 3 - 10 µm.

Die photopolymerisierbaren Materialien besitzen ihre maximale Empfindlichkeit im Ultraviolettbereich, bevorzugt im Wellenlängenbereich zwischen 250 und 450 nm. Die bildmäßige Belichtung der photopolymerisierbaren Schichten erfolgt daher mittels einer geeigneten Strahlungsquelle, wie z.B. Xenonlampen, Quecksilberdampflampen und Lasern.

Als Bildträgermaterialien eignen sich Substrate wie Papier, Pappe, Metalle, Folien oder Platten aus Polymeren wie z. B. Polyethylen, Polyvinylchlorid oder Polyamid, welche mit weiteren Hilfsschichten ausgerüstet sein können.

Das Tonen der bildmäßig belichteten Aufzeichnungsschicht kann sowohl durch Bestäuben mit überwiegend aus feinteiligen Pulvern bestehenden Tonermaterialien erfolgen, wie sie z. B. aus DE-C 29 46 896 und US 3,909,282 bekannt sind, wie auch mit pigmentierten Tonungsfolien, die das Tonermaterial lose gebunden auf einem gesonderten Träger enthalten. Solche Tonungsfolien werden z. B. in DE-C 39 41 493, DE-C 36 25 014 und EP-A 0 365 361 beschrieben.

Das erfindungsgemäße Material und Verfahren kann mit Vorteil zur Wiedergabe von Strich- und Rasteraufnahmen für die Anwendung im graphischen und sonstigen industriellen Bereichen und zur Herstellung gedruckter Schaltungen verwendet werden. Das Hauptanwendungsgebiet liegt in der Herstellung von Einoder Mehrfarbenbildern, insbesondere in der Verwendung für Farbprüfdrucke.

Die Herstellung eines Farbprüfdruckes gemäß der vorliegenden Erfindung umfaßt die folgenden Verfahrensschritte:

Das photopolymerisierbare Aufzeichnungsmaterial z.B. ein Laminat aus einer auf einen Schichtträger aufgetragenen photopolymerisierbaren Schicht mit einer Deckfolie wird nach Entfernung der Deckfolie auf ein Bildempfangsmaterial aufgebracht und durch den transparenten Schichtträger hindurch unter Verwendung eines gerasterten Farbauszugs-Positivs einer ersten Farbe als Vorlage mit aktinischer Strahlung zur Ausbildung von klebrigen und nicht klebrigen Bereichen belichtet.

Nach dem Entfernen des Schichtträgers wird die bildmäßig klebrige und nicht-klebrige Bereiche aufweisende Schicht an den klebrigen Bereichen getont. Hierzu wird ublicherweise eine pigmentierte Übertragungsschicht aufgebracht, und ihre Trägerfolie mit den nicht übertragenen Bereichen wieder abgezogen, oder ein Pulvertoner wird auf die klebrigen Bereiche der bildmäßig photopolymerisierten Schicht aufgebracht. Man erhält ein gefärbtes Bild der Vorlage.

Zur Herstellung eines Mehrfarbenprüfdrucks wird ein zweites Laminat des photopolymerisierbaren Aufzeichnungsmaterials nach Entfernung der Deckfolie auf das Bild auflaminiert und unter gleichen Bedingungen durch ein gerastertes Farbauszugspositiv einer zweiten Farbe als Vorlage belichtet und anschließend getont.

Dieser Vorgang wird dann für einen Farbauszug einer dritten Farbe und falls erwünscht, für einen Schwarzauszug wiederholt. Man erhält ein den Vorlagen entsprechendes farbiges Bild.

Die nachfolgenden Beispiele sollen die Erfindung veranschaulichen. Die angegebenen Teile und Prozente beziehen sich, falls nichts anderes angegeben ist, auf das Gewicht. Die mittleren Molekulargewichte der Polymere sind als Gewichtsmittel M_{w} angegeben.

### Beispiel 1 (Vergleichsbeispiel)

Es wurde ein Aufzeichnungsmaterial gemäß den Angaben des Beispiels 7 der EP-A 02 43 933 hergestellt. Die 15%ige Beschichtungslösung in einem Gemisch aus Toluol und Methanol (50/50 Vol.-%) enthielt:

| | |
|---|---|
| Ethylacrylat/Methylmethacrylat/Acrylsäure Copolymer(17/71/12), M _{w} = 200 000 | 25,00 g |
| | |
| Ethylacrylat/Methylmethacrylat/Acrylsäure Copolymer (57/39/4), M _{w} = 192 000 | 17,94 g |
| | |
| Ethylacrylat/Acrylsäure Copolymer (92/8) M _{w} = 7 000, Tg = -14° C | 5,58 g |
| | |
| Diacrylatester eines Bisphenol-A-Epoxydharzes, erhalten aus Bisphenol-A und Epichlorhydrin (Viskosität bei 25° C 1 000 000 cps) | 18,50 g |
| | |
| Trimethylolpropantrimethacrylat | 13,58 g |
| | |
| Trimethylolpropan | 5,05 g |
| | |
| Glycerintriacetat | 6,71 g |
| | |
| 7-(4'-Chloro-6'-diethylamino-1',3',5'-triazin-4'-yl)-amino-3-phenyl-cumarin | 2,05 g |
| | |
| 2-Mercaptobenzoxazol | 0,82 g |
| | |
| 2,2'-Bis(o-chlorophenyl)-4,4',5,5'-tetraphenylbiimidazol | 1,70 g |
| | |
| 1,4,4-Trimethyl-2,3-diazobicyclo-(3,2,2,)-non-2-en-2,3-dioxid | 0,05 g |
| | |
| Diethylhydroxylamin | 0,11 g |
| | |
| Methoxyhydrochinon | 0,02 g |
| | |
| Polycaprolacton, M _{w} = 30 000 | 0,60 g |
| | |
| Zinkacetylacetonat | 2,29 g |

Diese Gießlösung wurde so auf eine Polyethylenterephthalatfolie (12,5 µm) aufgetragen, daß nach dem Trocknen bei 55° C eine 4 µm dicke strahlungsempfindliche Schicht erhalten wurde. Anschließend wurde eine 19 µm starke Deckfolie aus Polypropylen auflaminiert. Dieses Material wurde zu einer Rolle aufgewickelt. Die Rolle wurde auf einem handelsublichen Cromalin® Whiteline-Laminator der Firma DuPont eingespannt, dessen Laminatorwalzentemperatur 95°C betrug. Nach 1 h Verweilzeit auf dem Laminator wurde die strahlungsempfindliche Schicht mit der Polyethylenterephthalatträgerfolie auf ein handelsübliches Cromalin® CP-2 Papier der Firma DuPont auflaminiert. Dabei wurde festgestellt, daß größere flächige Anteile der strahlungsempfindlichen Schicht beim Abziehen der Polypropylendeckfolie auf dem Laminator an der Deckfolie hängenblieben und nicht wie gewünscht auf das Papier auflaminiert wurden. Wegen dieser fehlerhaften Übertragung der strahlungsempfindlichen Schicht auf das Papier konnte kein brauchbarer Farbprüfdruck hergestellt werden.

### Beispiel 2 (Vergleichsbeispiel)

Wie in Beispiel 1 beschrieben wurde ein Aufzeichnungsmaterial aus der folgenden Gießlösung in einem Gemisch aus Toluol und Methanol (25/75 Vol.-%) als Rollenware hergestellt:

| | |
|---|---|
| Ethylacrylat/Methylmethacrylat/Acrylsäure Copolymer(17/71/12), M_{w} = 200 000 | 20,00 g |
| | |
| Ethylacrylat/Methylmethacrylat/Acrylsäure Copolymer (57/39/4), M_{w} = 192 000 | 26,25 g |
| | |
| Ethylacrylat/Acrylsäure Copolymer (92/8) M_{w} = 7 000, Tg = -14° C | 11,13 g |
| | |
| Trimethylolpropantrimethacrylat | 35,58 g |
| | |
| 7-(4'-Chloro-6'-diethylamino-1',3',5'-triazin-4'-yl)-amino-3-phenyl-cumarin | 2,05 g |
| | |
| 2-Mercaptobenzoxazol | 0,82 g |
| | |
| 2,2'-Bis(o-chlorophenyl)-4,4',5,5'-tetraphenylbiimidazol | |
| | |
| | |
| 1,4,4-Trimethyl-2,3-diazobicyclo-(3,2,2,)-non-2-en-2,3-dioxid | 0,05 g |
| | |
| Diethylhydroxylamin | 0,11 g |
| | |
| Methoxyhydrochinon | 0,02 g |
| | |
| Zinkacetylacetonat | 2,29 g |

Die Rolle wurde auf einem handelsüblichen Cromalin® Whiteline-Laminator der Firma DuPont eingespannt, dessen Laminatorwalzentemperatur 95°C betrug. Nach 2 h Verweilzeit auf dem Laminator wurde die strahlungsempfindliche Schicht mit der Polyethylenterephthalatträgerfolie auf ein handelsübliches Cromalin® CP-2 Papier der Firma DuPont auflaminiert. Die strahlungsempfindliche Schicht wurde vollständig auf das Papier übertragen. Mit Hilfe eines gerasterten Cyan-Farbauszugs-Positivs wurde die strahlungsempfindliche Schicht durch die Trägerfolie hindurch in einem handelsüblichen 1000W Cromalin® Whiteline-Belichtungsgerät der Firma Dupont belichtet. Nach dem Abziehen der Trägerfolie wurde in einer automatisierten Tonermaschine Cromalin® ATM III der Firma DuPont Cyan-Toner aufgebracht. Der Toner wurde von den unbelichteten, klebrigen Bereichen gut aufgenommen, und es wurde ein der Vorlage entsprechender Cyan-Auszug mit einer Auflösung von 2% - 98% Punkten bei einer Rasterweite von 60 Linien/cm erhalten. In den belichteten Bereichen, die eigentlich keinen Toner aufnehmen sollten, wurde deutlicher "pepper stain" festgestellt. Es konnte kein brauchbarer Farbprüfdruck erstellt werden.

### Beispiel 3

Wie in Beispiel 1 beschrieben wurde ein Aufzeichnungsmaterial aus der folgenden Gießlösung in einem Gemisch aus Toluol und Methanol (25/75 Vol.-%) als Rollenware hergestellt.

| | |
|---|---|
| Ethylacrylat/Methylmethacrylat/Acrylsäure Copolymer(17/71/12), M_{w} = 200 000 | 19,50 g |
| | |
| Ethylacrylat/Methylmethacrylat/Acrylsäure Copolymer (57/39/4), M_{w} = 192 000 | 14,07 g |
| | |
| Ethylacrylat/Acrylsäure Copolymer (92/8) M_{w} = 7 000, Tg = -14° C | 2,00 g |
| | |
| Copolymeres aus Vinylacetat und Crotonsäure, M_{w} 100000, Säurezahl 35 - 45 mg KOH/g Polymer | 20,00 g |
| | |
| Trimethylolpropantrimethacrylat | 31,58 g |
| | |
| Polyoxyethylen(4)-laurylether | 6,00 g |
| | |
| 7-(4'-Chloro-6'-diethylamino-1',3',5'-triazin-4'-yl)-amino-3-phenyl-cumarin | 2,05 g |
| | |
| 2-Mercaptobenzoxazol | 0,82 g |
| | |
| 2,2'-Bis(o-chlorophenyl)-4,4',5,5'-tetraphenylbiimidazol | 1,70 g |
| | |
| 1,4,4-Trimethyl-2,3-diazobicyclo-(3,2,2,)-non-2-en-2,3-dioxid | 0,05 g |
| | |
| Diethylhydroxylamin | 0,11 g |
| | |
| Methoxyhydrochinon | 0,02 g |
| | |
| Zinkacetylacetonat | 2,10 g |

Das so hergestellte Material wurde wie in Beispiel 2 beschrieben behandelt. Die strahlungsempfindliche Schicht wurde dabei vollständig auf das Papier übertragen, und es wurde ein Cyan-Farbauszug mit einer Auflösung von 2% - 98% Punkten bei einer Rasterweite von 60 Linien/cm erhalten. Die belichteten Bereiche hatten keinerlei Toner angenommen und waren somit vollständig frei von "pepper stain". Auch zeigte das erfindungsgemäße Material keine Löcher in der Photopolymerschicht, "pinholes", durch Herausreißen von Stücken der Photopolymerschicht beim Abziehen der Trägerfolie.

### Beispiel 4

Wie in Beispiel 1 beschrieben wurde ein Aufzeichnungsmaterial aus der folgenden Gießlösung in einem Gemisch aus Toluol und Methanol (25/75 Vol.-%) als Rollenware hergestellt:

| | |
|---|---|
| Ethylacrylat/Methylmethacrylat/Acrylsäure Copolymer(17/71/12), M_{w} = 200 000 | 18,00 g |
| | |
| Ethylacrylat/Acrylsäure Copolymer (92/8) M_{w} = 7 000, Tg = -14° C | 2,00 g |
| | |
| Copolymeres aus Vinylacetat und Crotonsäure, M_{w} 100000, Säurezahl 35 - 45 mg KOH/g Polymer | 35,67 g |
| | |
| ethoxyliertes Trimethylolpropantriacrylat, 3 Mol Ethylenoxid | 16,00 g |
| | |
| Trimethylolpropantrimethacrylat | 16,83 g |
| | |
| Polyoxyethylen(4)-laurylether | 5,75 g |
| | |
| 7-(4'-Chloro-6'-diethylamino-1',3',5'-triazin-4'-yl)-amino-3-phenyl-cumarin | 2,05 g |
| | |
| 2-Mercaptobenzoxazol | 0,82 g |
| | |
| 2,2'-Bis(o-chlorophenyl)-4,4',5,5'-tetraphenylbiimidazol | 1,70 g |
| | |
| 1,4,4-Trimethyl-2,3-diazobicyclo-(3,2,2,)-non-2-en-2,3-dioxid | 0,05 g |
| | |
| Diethylhydroxylamin | 0,11 g |
| | |
| Methoxyhydrochinon | 0,02 g |
| | |
| Zinkacetylacetonat | 1,00 g |

Das so hergestellte Material wurde wie in Beispiel 2 beschrieben behandelt. Die Auftragung des Tonermaterial erfolgte jedoch durch Auflaminieren und Abziehen einer handelsüblichen EuroSprint® Cyan-Übertragungsfolie der Firma DuPont. Die strahlungsempfindliche Schicht wurde dabei vollständig auf das Papier übertragen, und es wurde ein Cyan-Farbauszug mit einer Auflösung von 2% - 98% Punkten bei einer Rasterweite von 60 Linien/cm erhalten. Die belichteten Bereiche hatten keinerlei Toner angenommen und waren somit vollständig frei von "pepper stain". Auch zeigte das erfindungsgemäße Material keine Löcher in der Photopolymerschicht, "pinholes", durch Herausreißen von Stücken der Photopolymerschicht beim Abziehen der Trägerfolie.

### Beispiel 5

Wie in Beispiel 1 beschrieben wurde ein Aufzeichnungsmaterial aus der folgenden Gießlösung in einem Gemisch aus Toluol und Methanol (25/75 Vol.-%) als Rollenware hergestellt:

| | |
|---|---|
| Ethylacrylat/Methylmethacrylat/Acrylsäure Copolymer(17/71/12), M_{w} = 200 000 | 21,00 g |
| | |
| Ethylacrylat/Acrylsäure Copolymer (92/8) M_{w} = 7 000, Tg = -14° C | 2,00 g |
| | |
| Polyvinylacetathomopolymer, M_{w} 110000, Säurezahl 1-2 mg KOH/g Polymer | 33,67 g |
| | |
| ethoxyliertes Trimethylolpropantriacrylat, 3 Mol Ethylenoxid | 37,58 g |
| | |
| 7-(4'-Chloro-6'-diethylamino-1',3',5'-triazin-4'-yl)-amino-3-phenyl-cumarin | 2,05 g |
| | |
| 2-Mercaptobenzoxazol | 0,82 g |
| | |
| 2,2'-Bis(o-chlorophenyl)-4,4',5,5'-tetraphenylbiimidazol | 1,70 g |
| | |
| 1,4,4-Trimethyl-2,3-diazobicyclo-(3,2,2,)-non-2-en-2,3-dioxid | 0,05 g |
| | |
| Diethylhydroxylamin | 0,11 g |
| | |
| Methoxyhydrochinon | 0,02 g |
| | |
| Zinkacetylacetonat | 1,00 g |

Das so hergestellte Material wurde wie in Beispiel 2 beschrieben behandelt. Die Auftragung des Tonermaterials erfolgte sowohl mittels Tonerpulver als auch mittels einer Übertragungsfolie. Die strahlungsempfindliche Schicht wurde dabei vollständig auf das Papier übertragen, und es wurde ein Cyan-Farbauszug mit einer Auflösung von 2% - 98% Punkten bei einer Rasterweite von 60 Linien/cm erhalten. Die belichteten Bereiche hatten keinerlei Toner angenommen und waren somit vollständig frei von "pepper stain". Auch zeigte das erfindungsgemäße Material keine Löcher in der Photopolymerschicht, "pinholes", durch Herausreißen von Stücken der Photopolymerschicht beim Abziehen der Trägerfolie.

### Beispiel 6

Zur Herstellung eines Vierfarben-Prüfdrucks wurden vier Aufzeichnungsmaterialien gemäß Beispiel 3 und handelsübliche EuroSprint® Übertragungsschichten der Farben Cyan, Magenta, Gelb und Schwarz verwendet. Ein erstes Aufzeichnungsmaterial wird nach Entfernung der Deckfolie auf ein Bildempfangsmaterial auflaminiert und durch einen gerasterten positiven Cyan-Farbauszug in einem Vakuumkopierrahmen mit einer Metallhalogenidlampe (3 000 Watt) unter Verwendung eines Ultraviolett-durchlässigen Filters 42 s im Abstand von 95 cm belichtet. Nach Entfernung des Schichtträgers wird die Cyanübertragungsschicht auf die bildmäßig belichtete Schicht auflaminiert und sofort wieder abgezogen. Die Übertragungsschicht bleibt nur auf den unbelichteten, klebrigen Stellen haften, und man erhält ein positives Cyanbild der Vorlage.

Eine zweite Schicht des positiv tonbaren photopolymerisierbaren Aufzeichnungsmaterials wird auf das Cyanbild auflaminiert und wie oben durch den entsprechenden gerasterten Magenta-Farbauszug belichtet. Nach Entfernung des Schichtträgers wird die Magenta-Übertragungsschicht auf die bildmäßig belichtete Schicht auflaminiert und wieder abgezogen. Die Übertragungsschicht bleibt nur an den unbelichteten klebrigen Stellen haften, und man erhält ein positives Magentabild. Für die Farben Gelb und Schwarz werden die Arbeitsschritte entsprechend wiederholt und anschließend in üblicher Weise eine Schutzschicht aufgebracht. Man erhält einen Vierfarben-Prüfdruck von ausgezeichneter Brillianz und Schärfe mit einer Auflösung von 1% - 99% im 60-Linien/cm-Raster, der eine naturgetreue Wiedergabe des Originals darstellt. Sowohl die Deckfolien als auch die Trägerschichten der Aufzeichnungsmaterialien ließen sich leicht und ohne Fehler abziehen, und die strahlungsempfindlichen Schichten wurden vollständig übertragen. Die Haftung der Aufzeichnungsschichten untereinander und auf dem Bildempfangsmaterial war ausgezeichnet. Es wurden weder "peeper stain" noch "pinholes" beobachtet.

## Patentansprüche

1. Verfahren zur Herstellung von Farbprüfdrucken umfassend,
a) Abziehen des Schichtträgers eines photopolymerisierbaren Aufzeichnungsmaterials umfassend einen Schichtträger, eine photopolymerisierbare Schicht, welche ein polymeres Bindemittel mit salzbildenden Gruppen oder ein Bindemittelgemisch mit wenigstens einem Polymeren mit salzbildenden Gruppen, mindestens ein photopolymerisierbares Monomer und einen Photoinitiator oder ein Photoinitiatorsystem enthält, und eine Deckfolie,
b) Laminieren des photopolymerisierbaren Aufzeichnungsmaterials mit der photopolymerisierbaren Schicht auf ein Bildträgermaterial,
c) ggf. Abziehen der Deckfolie,
d) bildmäßiges Belichten der photopolymerisierbaren Schicht zur Erzeugung klebriger und nicht klebriger Bereiche,
e) Entfernen der Deckfolie, falls dies noch nicht unter c) erfolgt ist, und
f) Aufbringen von Toner auf die klebrigen Bereiche der bildmäßig belichteten Schicht,
**dadurch gekennzeichnet, dass**
die photopolymerisierbare Schicht mindestens 10 Gew.-% wenigstens eines Vinylacetathomopolymeren und/oder -copolymeren bezogen auf den Gesamtfeststoffgehalt der photopolymerisierbaren Schicht enthält.

2. Verfahren nach Anspruch 1,
**dadurch gekennzeichnet, dass**
die Schritte a) bis f) mehrfach wiederholt werden, wobei unter a) ein neues photopolymerisierbares Aufzeichnungsmaterial verwendet wird und diese unter b) auf die gemäß den vorhergehenden Schritten behandelte Schicht aufgebracht wird.

3. VerFahren nach einem der Ansprüche 1 oder 2,
**dadurch gekennzeichnet, dass**
ein Vinylacetatcopolymer mit Crotonsäure als Comonomer verwendet wird.

4. Verfahren nach einem der Ansprüche 1 bis 3,
**dadurch gekennzeichnet, dass**
ein Vinylacetathomopolymer oder -copolymer mit einem mittleren Molekulargewicht M_{w} von 35000 bis 150000 verwendet wird.

5. Verfahren nach einem der Ansprüche 1 bis 4,
**dadurch gekennzeichnet, dass**
die photopolymerisierbare Schicht 18 bis 40 Gew.-% Vinylacetathomopolymer oder - copolymer bezogen auf den Gesamtfeststoffgehalt der photopolymrisierbaren Schicht enthält.

6. Verfahren nach einem der Ansprüche 1 bis 5,
**dadurch gekennzeichnet, dass**
als weitere Bindemittel Copolymere von (Meth)acrylsäure mit Methyl- und/oder Ethylacrylat bzw. -methacrylat verwendet werden.

7. Verfahren nach einem der Ansprüche 1 bis 6,
**dadurch gekennzeichnet, dass**
die photopolymerisierbare Schicht eine mehrwertige Metallverbindung aus den Gruppen II A - IV A, II B- IV B und VII B des Periodensystems enthält.

## Claims

1. Process for the production of color proofs comprising
a) pulling off the substrate of a photopolymerizable recording material comprising a substrate, a photopolymerizable layer which comprises a polymeric binder with salt-forming groups or a binder mixture with at least one polymer with salt-forming groups, at least one photopolymerizable monomer, and a photoinitiator or a photoinitiator system, and a cover film,
b) laminating the photopolymerizabel recording material with the photopolymerizable layer onto an image carrier material,
c) optionally pulling off the cover film
d) imagewise exposing the photopolymerizable layer in order to generate tacky and non-tacky areas,
e) pulling off the cover film, if this was not done under c),
f) applying toner onto the tacky areas of the imagewise exposed layer,
**characterized in that**,
the photopolymerizabel layer comprises at least 10 % by weight of at least one vinyl acetate homopolymer and/or copolymer based on the total solids content of the photopolymerizable layer.

2. Process according to claim 1
**characterized in that**,
the steps a) through f) are repeated several times, wherein under a) a new photopolymerizable recording material is employed and this material is applied under b) onto the layer treated according to the preceding steps.

3. Process according to one of the claims 1 to 2
**characterized in that**,
a vinyl acetate copolymer with crotonic acid as comonomer is used.

4. Process according to one of the claims 1 to 3
**characterized in that**,
a vinyl acetate homopolymer or copolymer with a mean molecular weight M_{w} of 35000 to 150000 is used.

5. Process according to one of the claims 1 to 4
**characterized in that**,
the photopolymerizable layer comprises 18 to 40 % by weight of vinyl acetate homopolymer or copolymer based on the total solids content of the photopolymerizable layer.

6. Process according to one of the claims 1 to 5
**characterized in that**,
copolymers of (meth)acrylic acid with methyl and/or ethyl acrylate and/or methylacrylate are used as further binders.

7. Process according to one of the claims 1 to 6
**characterized in that**,
the photopolymerizable layer comprises a polyvalent metal compound from the groups II A - IV A, II B - IV B and VII B of the periodic table of elements.

## Revendications

1. Procédé de fabrication d'épreuves couleur comprenant
a) le détachement d'un subjectile de couche d'un matériau d'enregistrement photopolymérisable comprenant un subjectile de couche, une couche photopolymérisable, qui contient un liant polymère à groupements formant des sels ou un mélange de liants avec au moins un polymère ayant des groupements formant des sels, au moins un monomère photopolymérisable et un agent photoinitiateur ou un système d'agents photoinitiateurs, et une feuille de finition,
b) le laminage du matériau d'enregistrement photopolymérisable avec la couche photopolymérisable sur un matériau subjectile d'image,
c) le cas échéant, l'enlèvement de la feuille de finition,
d) l'exposition par image de la couche photopolymérisable en vue de la production de domaines collants et de domaines non collants,
e) le détachement de la feuille de finition, au cas où ceci n'a pas déjà eu lieu sous le point c), et
f) l'application de toner sur les domaines collants de la couche exposée par images,
**caractérisé en ce que** la couche photopolymérisable contient au moins 10% en poids d'au moins un homopolymère et/ou un copolymère de l'acétate de vinyle, par rapport à la teneur globale en matières solides de la couche photopolymérisable.

2. Procédé selon la revendication 1, **caractérisé en ce que** les étapes a) à f) sont répétées à plusieurs reprises, en utilisant sous a) un nouveau matériau d'enregistrement photopolymérisable et en appliquant ce dernier sous b) sur la couche traitée conformément aux étapes précédentes.

3. Procédé selon l'une des revendications 1 ou 2, **caractérisé en ce que** l'on utilise un copolymère de l'acétate de vinyle avec l'acide crotonique en tant que comonomère.

4. Procédé selon l'une des revendications 1 à 3, **caractérisé en ce que** l'on utilise un homopolymère ou un copolymère de l'acétate de vinyle ayant un poids moléculaire moyen M_{w} de 35 000 à 150 000.

5. Procédé selon l'une des revendications 1 à 4, **caractérisé en ce que** la couche photopolymérisable contient de 18 à 40% en poids de l'homopolymère ou du copolymère de l'acétate de vinyle, par rapport à la teneur globale en matières solides de la couche photopolymérisable.

6. Procédé selon l'une des revendications 1 à 5, **caractérisé en ce que** l'on utilise, en tant que liant supplémentaire, des copolymères de l'acide (méth)acrylique avec l'acrylate, respectivement le méthacrylate, de méthyle et/ou d'éthyle.

7. Procédé selon l'une des revendications 1 à 6, **caractérisé en ce que** la couche photopolymérisable contient un composé métallique polyvalent provenant des groupes II A - IV A, II B - IV B et VII B du système périodique.
